# FASCICULE DE BREVET EUROPEEN

(11) **EP 1 898 610 B1**
(45) Date de publication et mention de la délivrance du brevet: **10.12.2008**
(21) Numéro de dépôt: 07111388.0
(22) Date de dépôt: 29.06.2007
(51) Int. Cl.: H04M 1/04, H05K 5/02

(54) **Dispositif déshumidificateur pour matériels électroniques rechargeables**
Entfeuchtervorrichtung für wiederaufladbare elektronische Materialien
Dehumidifier device for rechargeable electronic equipment

(30) Priorité: 05.09.2006 FR 0653581
(43) Date de publication de la demande: 12.03.2008
(73) Titulaire: Societé Française du Radiotéléphone, 75008 Paris (FR)
(72) Inventeur: Faisy, Christian, 97417, La Montagne (FR)
(74) Mandataire: Schmit, Christian Norbert Marie

(56) Documents cités:
- WO-A-20/06058265
- BE-A7- 1 013 605
- DE-A1-4102004 006 38
- GB-A- 2 314 920

## Description

L'invention a pour objet un dispositif déshumidificateur pour un ou plusieurs matériels électroniques rechargeables

Le domaine de l'invention est celui du maintien en conditions optimales d'utilisation des dispositifs électroniques rechargeables dont l'utilisation dans des conditions de forte hygrométrie peut nuire à leur bon fonctionnement. Plus précisément l'invention est du domaine des dispositifs électroniques de télécommunications ces dispositifs étant des terminaux mobiles, par exemple, de clients d'un opérateur de téléphonie mobile, ces clients utilisant parfois ledit terminal mobile dans des conditions de saturation hygrométrique (pluie, brouillard, environnement marin et plus généralement climat tropical).

Un but de l'invention est d'accroître la durée de bon fonctionnement et par là la durée de vie des matériels électroniques rechargeables lorsqu'ils sont utilisés dans ces environnements à forte saturation hygrométrique.

Dans l'état de la technique on sait que la présence d'humidité sur les composants des matériels électroniques favorise la corrosion. L'utilisation diurne de tels matériels dans des conditions d'hygrométrie proches de la saturation favorise l'infiltration d'humidité dans lesdits matériels et le dépôt de molécules d'eau sur les circuits et/ou composants desdits matériels. Une partie de ces molécules se dépose sur les pièces métalliques constituant les circuits et/ou composants électroniques déclenchant ainsi une oxydation desdits circuits ou composants. L'oxydation des circuits ou composants électroniques peut donc être importante et provoquer des dysfonctionnements parfois irréversibles.

Dans l'état actuel de la technique il est connu que l'usage des agents dessiccatifs, comme par exemple des cristaux de silice, qui sont conditionnés dans un sachet poreux, ledit sachet étant alors placé avec l'appareil électronique à protéger et l'ensemble dans un environnement confiné,, permettent de réduire ce phénomène d'oxydation. De telles solutions présentent l'inconvénient principal, outre le côté peu pratique et la faible efficacité dans un environnement non confiné ou présentant un taux d'hygrométrie proche de celui ayant entraîné préalablement le dépôt de molécules d'eau, de requérir le changement régulier des sachets de dessiccateur qui sont rapidement saturés d'eau. La méthode est donc peu fiable et les effets d'absorption des molécules d'eau sont liés aux conditions d'utilisation des sachets d'une part et à leur état d'usage (neuf ou saturé), le second état étant irréversible.

Une autre solution de l'état de la technique consiste à entreposer les matériels électroniques dans une pièce à hygrométrie constante et contrôlée. Cependant le propre d'un appareil mobile étant d'être en permanence à portée de l'utilisateur, le fait de le stocker dans un tel environnement serait contraire à sa destination originale. La présente invention améliore l'art existant en mettant à profit la nécessaire recharge en énergie des matériels électroniques rechargeables (nocturne de manière générale) garantissant leur disponibilité et leur autonomie de fonctionnement (diurne le plus souvent). Le chargeur généralement fourni avec lesdits matériels est un convertisseur de moyenne à basse tension qui produit de manière induite à son fonctionnement, une énergie calorifique propre à pouvoir absorber l'humidité contenue dans les matériels électroniques rechargeables à condition que ces derniers soient placés, selon l'invention, avec le chargeur dans un environnement confiné au travers duquel un système de ventilations haute et basse permet une circulation d'air par convection thermique, facilitant ainsi l'évacuation hors de la zone de confinement de l'humidité contenue dans le matériel grâce au courant d'air chaud ainsi produit.

L'invention consiste en un dispositif associant une zone de confinement apte à contenir l'appareil électronique rechargeable que l'on souhaite déshumidifier, à un chargeur relié au réseau électrique de moyenne tension (220V ou 110V) via un câble d'alimentation. La fonction première du chargeur est bien entendu également ici de transformer une moyenne tension en basse tension permettant de recharger le ou les matériels électroniques rechargeables disposés dans la capsule de confinement. La chaleur produite par l'échauffement de la bobine du chargeur lors de la conversion de tension, est utilisée directement comme élément de déshumidification du matériel électronique rechargeable placé dans la zone de confinement. Dans la présente invention, le chargeur est positionné en partie basse d'une capsule de confinement à laquelle il est intégré. Le chargeur est percé sur ses parties hautes et basses de trous d'évent permettant une libre circulation de l'air par effet de convection thermique lorsque le chargeur dégage une énergie calorifique induite par la bobine du composant. Cet effet est obtenu lorsque le dispositif de charge est relié au réseau électrique. En partie haute du chargeur, un connecteur permet de brancher l'appareil électronique rechargeable sur le chargeur. La capsule de confinement, dans le mode préféré de réalisation de l'invention, est composée d'au moins deux parties mobiles s'ouvrant et se refermant hermétiquement. Ces parties mobiles permettent d'ouvrir le dispositif de confinement de manière à pouvoir placer le matériel électronique rechargeable sur le chargeur et ainsi permettre la recharge de la batterie dudit matériel. La capsule de confinement en mode hermétique (refermée) présente des trous d'évent sur ses parties haute et basse de manière à permettre la libre circulation de l'air dans la capsule.

L'invention a donc pour objet un dispositif déshumidificateur pour matériel électronique rechargeable caractérisé en ce qu'il comporte :
- un chargeur apte à recevoir le matériel électronique rechargeable pour assurer la recharge dudit matériel électronique rechargeable,
- une capsule de confinement fixée au chargeur,
- un système d'ouverture de la capsule de confinement permettant la mise en place du matériel électronique rechargeable relié au chargeur par un dispositif de connexion,
- des trous d'évent sur la partie supérieure de la capsule de confinement permettant à l'air chaud de sortir de la capsule de confinement,
- des trous d'évent sur la partie inférieure de la capsule de confinement ou du chargeur celui-ci faisant alors office de socle au dispositif, permettant à de l'air extérieur d'entrer et de circuler dans la capsule de confinement.

Ainsi, le dispositif déshumidificateur comporte des trous d'évent permettant la libre circulation d'air à l'intérieur du dispositif, de bas vers le haut, les trous d'évent en bas du dispositif permettant à l'air extérieur d'entrer d'une part, puis d'être aspiré par convection (lorsque le chargeur est relié à une source d'alimentation de moyenne tension) pour ressortir par les trous d'évent des parties supérieures du dispositif.

Dans une variante de l'invention la surface des trous d'évent sur la partie supérieure de la capsule de confinement est inférieure à la surface des trous d'évent sur la partie inférieure de la capsule de confinement ou du chargeur..

Cette situation permet à l'air chaud d'être présent pour une durée plus longue dans la capsule de confinement, que si les surfaces de trous d'évent étaient équivalentes (l'air circulerait alors de manière fluide et non turbulente).

Dans une variante de l'invention la capsule de confinement est réalisée dans un matériau étanche à l'énergie calorifique aux propriétés isothermes.

Ainsi, l'ensemble du dispositif est avantageusement hermétique une fois le matériel électronique rechargeable placé à l'intérieur pour la séquence de charge/déshumidification.

Dans une variante de l'invention la capsule de confinement est translucide afin de permettre à un utilisateur de visualiser le matériel électronique mobile inséré dans ledit dispositif.

Dans le mode préféré de réalisation de l'invention, la capsule de confinement est rigide.

Dans une variante de l'invention la capsule de confinement est constituée d'un matériau souple formant au moins une membrane souple, la rigidité du dispositif étant obtenue par des arceaux ou par injection d'air entre des membranes de la capsule.

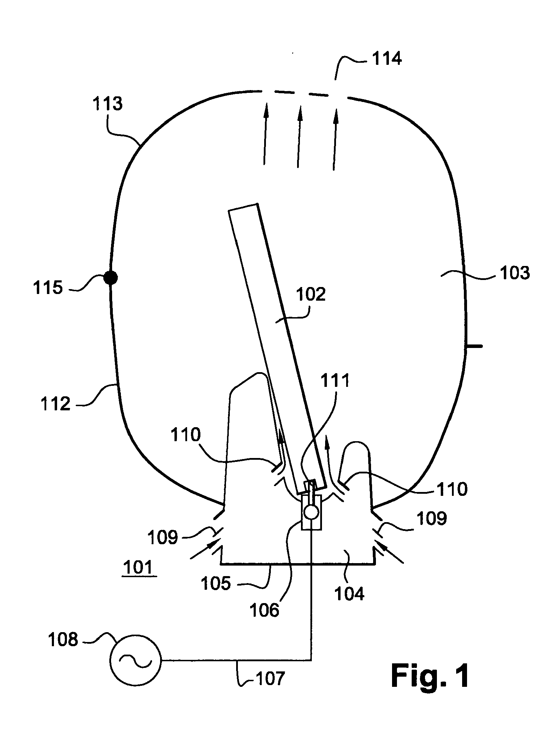

L'invention sera mieux comprise à la lecture de la description qui suit et à l'examen de la figure qui l'accompagne. Celle-ci est présentée à titre indicatif et nullement limitatif de l'invention. La figure 1 montre une représentation du dispositif selon l'invention.

Ainsi, la figure 1 montre un dispositif déshumidificateur 101 sur lequel est branché, dans un exemple préféré de matériel électronique rechargeable, un téléphone mobile 102. Toutefois, la présente invention est adaptée à tous les types d'appareils électroniques devant être rechargés. L'homme de l'art comprendra aisément qu'il suffit alors d'adapter la taille de la capsule de confinement aux dimensions de l'appareil électronique à recharger.

Le dispositif 101 est composé d'une capsule de confinement 103 qui intègre un dispositif chargeur 104.

Le dispositif chargeur 104 est composé de deux parties:
- un support 105 apte à maintenir en place un appareil électronique à recharger, et
- un convertisseur de tension 106 fixé au support 105 connecté au matériel électronique à recharger, maintenu par ledit support .Le convertisseur 106 est aussi connecté à une source de moyenne tension 108 via un câble d'alimentation 107. Une source de moyenne tension est, par exemple, une prise murale raccordée au réseau d'un distributeur d'énergie. La conversion de tension a, entre autres, pour effet une augmentation de la température de la bobine contenue dans le convertisseur. Cette source de chaleur est celle avantageusement utilisée dans la présente invention.

Le dispositif chargeur est donc au moins en partie contenu par la capsule de confinement. La partie du chargeur contenue par la capsule de confinement est la partie apte à recevoir le dispositif à recharger.

Le convertisseur 106 comporte aussi, sur sa partie haute, un connecteur 111 permettant de connecter le téléphone 102 audit convertisseur. Dans un mode de réalisation préféré de l'invention le téléphone 102 est placé directement sur le connecteur 111. Dans une variante ce connecteur est déporté du support 105 au moyen d' un câble.

La figure 1 montre aussi des trous d'évent 109 situés sur la partie basse du socle 105. On considère ici que la partie basse du support 105 est celle située en-dessous du convertisseur 106.. La figure 1 montre que la capsule 103 est associée au support 105 par une fixation située au-dessus des trous d'évent 109.

Le support 105 comporte des trous d'évent 110 situés au-dessus des trous d'évent 109 à l'intérieur de la capsule 103. Les trous 110 sont de préférence situés à proximité de la base du téléphone 102 lorsque celui-ci est placé sur ledit support 105. Les trous 110 peuvent aussi être répartis sur toute la surface du support 105 située à l'intérieur de la capsule 103. Les trous 110 agissent alors comme des dissipateurs thermiques.

Lorsqu'un téléphone est placé sur le support 105, le convertisseur 106 produit de la chaleur qui chauffe l'air contenu au voisinage du support 105 et finalement au sein de la capsule 103. Cet air chaud, c'est-à-dire à une température supérieure à la température ambiante (à l'intérieur de la capsule de confinement, du support 105 et donc au voisinage du dispositif), s'échappe alors par les trous d'évent 110 réchauffant ainsi la température à l'intérieur de la capsule 103 et provoquant un flux d'air le long du téléphone 102. L'air chaud s'échappant par les trous d'évent 110 est remplacé par de l'air à température ambiante (extérieure à la capsule de confinement) arrivant via les trous d'évent 109.

Dans le mode de réalisation préféré décrit, les trous d'évent sont agencés de manière à laisser circuler l'énergie calorifique dégagée par le convertisseur 106 et véhiculée grâce à la circulation d'air dans le dispositif. Cette circulation s'effectue dans le sens du bas vers le haut de la capsule 103. L'invention exploite donc le phénomène de convection thermique naturelle qu'est la circulation des masses d'air du bas vers le haut lorsque ces dernières rencontrent des sources de chaleur en milieu confiné.

La capsule 103 comporte sur sa partie supérieure des trous d'évent 114 permettant à l'air chaud de sortir de la capsule. Dans le mode préféré de réalisation de l'invention, la surface des trous d'évent permettant à l'air de sortir de la capsule 103 est inférieure à la surfaces des trous d'évent permettant à l'air d'entrer dans la capsule 103. Cela a pour effet de maintenir dans la capsule une température élevée, c'est-à-dire supérieure à la température ambiante. Le maintien d'une température élevée au sein de la capsule favorise l'absorption de l'humidité du fait de l'air chaud y circulant.

A cet effet, la capsule de confinement est réalisée dans un matériau aux qualités isothermes reconnues. Ce matériau sera de préférence mais pas nécessairement transparent, pour permettre à un utilisateur de lire les informations affichées sur l'écran du téléphone 102. Ces informations portent, entre autres, sur l'état de charge de la batterie du téléphone 102.

Des matériaux étanches à l'énergie calorifique aux propriétés isothermes reconnues comme, par exemple, le polyvinyle, le polycarbonate, ou le PVC (Poly Vinyle Chloride pour polychlorure de vinyle) utilisés en couche unique épaisse ou en deux couches minces séparées par de l'air ou tout autre matériau isolant (mousse polyuréthane, feuille d'aluminium, polycarbonate, ...) ou encore la combinaison d'au moins 2 des matériaux cités (face intérieure/extérieure ou bien en "sandwich" 1/2/1 ou 2/1/2). Ces matériaux cités ont la particularité d'être transparents, ou au moins translucides, en plus d'avoir des propriétés isothermes et en plus d'être doté d'une excellente résistance à la déformation thermique. L'un, ou plusieurs de ces matériaux, seront donc avantageusement utilisés pour la présente application.

Dans la mesure ou on connaît dans l'art antérieur des phénomènes de turbulences et de variations locales de densité de l'air liées au mode de circulation des fluides depuis des trous d'évent en partie basse vers des trous d'évent en partie haute, il est intéressant, dans une variante de l'invention, de doter les parois internes de la capsule de caractéristiques telles que ces parois réfléchissent la chaleur reçue de manière à garantir la stabilité en température, donc une densité homogène de l'air dans la capsule de confinement et donc un écoulement optimal de cet air du bas vers le haut.

Cette propriété de réflexion est soit intrinsèque au matériel utilisé pour réaliser la capsule, soit obtenu via une couche d'un matériel ad hoc disposé sur les parois internes de la capsule 103.

La figure 1 montre que la capsule 103 comporte deux parties rigides. Une partie inférieure 112 fixée au support 105 et une partie 113 amovible. Dans une variante de l'invention les parties 112 et 113 sont en contact, lorsque la capsule est fermée, via un joint assurant l'étanchéité entre les parties 112 et 113.

La mobilité entre les parties 112 et 113 est réalisée, dans un premier exemple, selon deux parties mécaniquement distinctes, comme un couvercle sur un récipient.

Dans un autre exemple, la mobilité entre les parties 112 et 113 est réalisée au moyen d'une articulation, une charnière 115 par exemple, permettant à la partie 113 de basculer relativement à la partie 112. L'ouverture de la partie 113 permet de mettre le téléphone 102 en place sur le support 105. La mobilité relative des parties 112 et 113 permet de ménager une ouverture dans la capsule 103.

Une fois la capsule de confinement refermée, le téléphone 102 ayant été préalablement positionné sur le connecteur 111, le convertisseur 106 dégage une énergie calorifique due à l'échauffement de ses composants. L'énergie calorifique ainsi obtenue est naturellement distribuée vers les trous d'évent 114, via les trous d'évent 110, et ce par effet de convection thermique.

De l'air à température ambiante entre dans la capsule 103 via les trous d'évent 109 pour être chauffé et circuler dans la capsule 103. Cette convection d'air chaud favorise l'évaporation des molécules d'eau formées sur les circuits et/ou composants dans le téléphone 102. Le dispositif selon l'invention permet de contraindre les molécules d'eau contenues dans le téléphone 102 à rompre tout contact avec des pièces électroniques constituant pour partie le téléphone 102. Ces molécules d'eau sont donc évacuées par la convection thermique obtenue par le confinement et l'énergie calorifique dégagée par le convertisseur 106.

Les cycles normaux de charge du téléphone 102 permettent d'éliminer régulièrement les molécules d'eau et donc d'éviter le phénomène d'oxydation obtenu par réaction lente des molécules d'eau sur les circuits ou pièces métalliques contenus dans le téléphone 102.

Dans une variante de l'invention les parois de la capsule 103 sont réalisées dans un matériau souple formant alors une poche. Sur sa partie supérieure cette poche comporte alors un disque rigide dans lequel sont pratiqués les trous d'évent 114. L'ouverture et la fermeture sont réalisées via un dispositif du type de celui existant pour les sacs de congélation d'aliments. Le positionnement des trous d'évent 114 au somment du dispositif est obtenu par le téléphone 102 lui-même qui supporte alors le disque dans lequel lesdits trous d'évent ont été pratiqués.

Dans cette variante l'utilisation d'un disque rigide est facultative. Les trous d'évent d'évacuation de l'air sont alors des orifices aux bords renforcés pratiqués dans la membrane souple.

Dans cette variante souple, la capsule peut être rendu rigide par des arceaux gonflables ou démontables. Le fait de gonfler, ou d'assembler, ces arceaux procure alors une armature rigide aux différentes parties de la capsule.

Cette rigidité peut aussi être obtenue par la mise en oeuvre d'une membrane à double parois, l'espace entre les parois pouvant alors être gonflé procurant ainsi sa rigidité à la capsule.

Les modes de réalisation de la capsule ne manquent pas.

## Revendications

1. Dispositif déshumidificateur (101) pour matériel électronique rechargeable (102) **caractérisé en ce qu'**il comporte :
- un chargeur (104-106) apte à recevoir le matériel électronique rechargeable (102) pour assurer la recharge dudit matériel électronique rechargeable,
- une capsule de confinement (103) fixée au chargeur,
- un système d'ouverture (112, 113) de la capsule de confinement permettant la mise en place du matériel électronique rechargeable (102) relié au chargeur par un dispositif de connexion (111),
- des trous d'évent (114) sur la partie supérieure de la capsule de confinement permettant à l'air chaud de sortir de la capsule de confinement (103),
- des trous d'évent (109, 110) sur la partie inférieure de la capsule de confinement ou du chargeur celui-ci faisant alors office de socle au dispositif, permettant à de l'air extérieur d'entrer et de circuler dans la capsule de confinement (103).

2. Dispositif selon la revendication 1, **caractérisé en ce que** la surface des trous d'évent sur la partie supérieure de la capsule de confinement est inférieure à la surface des trous d'évent sur la partie inférieure de la capsule de confinement ou du chargeur.

3. Dispositif selon l'une des revendications 1 ou 2, **caractérisé en ce que** la capsule de confinement est réalisée dans un matériau étanche à l'énergie calorifique aux propriétés isothermes.

4. Dispositif selon l'une des revendications 1 à 3, **caractérisé en ce que** la capsule de confinement est translucide afin de permettre à un utilisateur de visualiser le matériel électronique mobile inséré dans ledit dispositif.

5. Dispositif selon les revendications 2 à 4, **caractérisé en ce que** la capsule de confinement est rigide.

6. Dispositif selon les revendications 2 à 4, **caractérisé en ce que** la capsule de confinement est constituée d'un matériau souple formant au moins une membrane souple, la rigidité du dispositif étant obtenue par des arceaux ou par injection d'air entre des membranes de la capsule.

7. Dispositif selon l'une des revendications 1 à 6, **caractérisé en ce que** l'ensemble du dispositif est hermétique une fois le matériel électronique rechargeable placé à l'intérieur pour la séquence de charge/déshumidification.

8. Dispositif selon l'une des revendications 1 à 7, **caractérisé en ce que** le chargeur (106) comporte un connecteur (111) permettant d'y relier un matériel électronique rechargeable.

## Claims

1. A dehumidifying device (101) for rechargeable electronic apparatus (102) **characterised in that** it comprises:
- a charger (104-106) able to receive the rechargeable electronic apparatus (102) to recharge the said rechargeable electronic apparatus,
- a confinement capsule (103) fixed to the charger,
- a system for opening (112, 113) the confinement capsule enabling the positioning of the rechargeable electronic apparatus (102) linked to the charger by a connection device (111),
- venting holes (114) on the upper part of the confinement capsule allowing hot air to exit the confinement capsule (103),
- venting holes (109, 110) on the lower part of the confinement capsule or the charger which is thus the base of the device, allowing outside air to enter and circulate in the confinement capsule (103).

2. A device according to claim 1, **characterised in that** the surface of the venting holes on the upper part of the confinement capsule is smaller than the surface of the venting holes on the lower part of the confinement capsule or the charger.

3. A device according to one of claims 1 or 2, **characterised in that** the confinement capsule is made of a material resistant to calorific energy of isothermal properties.

4. A device according to claims 1 to 3, **characterised in that** the confinement capsule is transparent so that a user can see the mobile electronic apparatus inserted in the said device.

5. A device according to claims 2 to 4, **characterised in that** the confinement capsule is rigid.

6. A device according to claims 2 to 4, **characterised in that** the confinement capsule is made of a flexible material forming at least one supple membrane, the rigidity of the device being obtained by hoops or by air injected between the capsule membranes.

7. A device according to claims 1 to 6, **characterised in that** the whole of the device is hermetic once the rechargeable electronic apparatus is placed inside for the sequence of charging/dehumidifying.

8. A device according to one of claims 1 to 7, **characterised in that** the charger (106) comprises a connector (111) for connecting a rechargeable electronic apparatus.

## Patentansprüche

1. Vorrichtung zum Entfeuchten (101) von aufladbaren elektronischen Geräten (102), **dadurch gekennzeichnet, dass** sie folgende Elemente enthält:
- ein Ladegerät (104-106), das das aufladbare elektronische Gerät (102) aufnehmen kann, um das besagte aufladbare elektronische Gerät aufzuladen,
- eine Verschlusskapsel (103), die am Ladegerät befestigt ist,
- ein System zum Öffnen (112, 113) der Verschlusskapsel zum Anbringen des aufladbaren elektronischen Geräts (102), das durch eine Anschlussvorrichtung (111) mit dem Ladegerät verbunden ist,
- Luftlöcher (114) am oberen Abschnitt der Verschlusskapsel, durch die die warme Luft aus der Verschlusskapsel (103) entweichen kann,
- Luftlöcher (109, 110) am unteren Abschnitt der Verschlusskapsel oder des Ladegerätes, wobei dieses dann als Sockel für die Vorrichtung dient, durch die die Außenluft einströmen, und in der Verschlusskapsel (103) zirkulieren kann.

2. Vorrichtung nach Anspruch 1, **dadurch gekennzeichnet, dass** die Größe der Luftlöcher am oberen Abschnitt der Verschlusskapsel kleiner ist, als die Größe der Luftlöcher am unteren Abschnitt der Verschlusskapsel oder des Ladegerätes.

3. Vorrichtung nach einem der Ansprüche 1 oder 2, **dadurch gekennzeichnet, dass** die Verschlusskapsel aus einem thermodichten Material mit isothermen Eigenschaften gefertigt ist.

4. Vorrichtung nach einem der Ansprüche 1 bis 3, **dadurch gekennzeichnet, dass** die Verschlusskapsel durchsichtig ist, damit ein Benutzer in der Lage ist, das elektronische Gerät zu sehen, das in die besagte Vorrichtung eingelegt ist.

5. Vorrichtung nach den Ansprüchen 2 bis 4, **dadurch gekennzeichnet, dass** die Verschlusskapsel steif ist.

6. Vorrichtung nach den Ansprüchen 2 bis 4, **dadurch gekennzeichnet, dass** die Verschlusskapsel aus einem weichen Material besteht, das zumindest eine weiche Membran bildet, wobei die Steifigkeit der Vorrichtung durch Bügel oder durch das Einblasen von Luft zwischen die Membrane der Kapsel erzielt wird.

7. Vorrichtung nach einem der Ansprüche 1 bis 6, **dadurch gekennzeichnet, dass** die gesamte Vorrichtung hermetisch ist, sobald das aufladbare elektronische Gerät im Inneren der Vorrichtung zum Laden/ Entfeuchten Platz gefunden hat.

8. Vorrichtung nach einem der Ansprüche 1 bis 7, **dadurch gekennzeichnet, dass** das Ladegerät (106) einen Steckplatz (111) enthält, an den ein aufladbares elektronisches Gerät angeschlossen werden kann.
